Europäisches Patentamt

European Patent Office

Office européen des brevets

(19)

(11) Numéro de publication: **0 192 061 B1**

(12) **FASCICULE DE BREVET EUROPEEN**

(45) Date de publication du fascicule du brevet:
08.08.90

(51) Int. Cl.⁵: **H03G 3/20**, H04B 7/185

(21) Numéro de dépôt: **86100711.0**

(22) Date de dépôt: **21.01.86**

(54) Dispositif de commande automatique de gain d'un récepteur en accès multiple à répartition temporelle.

(30) Priorité: **22.01.85 FR 8500859**

(43) Date de publication de la demande:
**27.08.86 Bulletin 86/35**

(45) Mention de la délivrance du brevet:
**08.08.90 Bulletin 90/32**

(84) Etats contractants désignés:
**DE FR GB IT**

(56) Documents cités:
**EP-A- 0 099 702
EP-A- 0 151 916
US-A- 4 330 859**

**IEEE INTERNATIONAL CONFERENCE ON
COMMUNICATIONS: INTEGRATING COMMUNICATION
FOR WORLD PROGRESS, Boston,
Massachusetts, 19-22 juin 1983, Conference Record,
vol. 1/3, pages 387-391, IEEE, New York, US; R.L.
WALLACE: "Design features and performance of a high
speed TDMA demodulator" 000
NTC '77 CONFERENCE RECORD,
vol. 3, 1977, pages 43:2-1 - 43:2-3, IEEC, New York, US;
D.J. SCHAEFER: "A technique for TDMA burst power
measurement"**

(73) Titulaire: **ALCATEL TRANSMISSION PAR FAISCEAUX
HERTZIENS A.T.F.H., 55, rue Greffulhe,
F-92300 Levallois-Perret Cédex(FR)**

(72) Inventeur: **Meuriche, Bernard, 150 avenue de
Saint-Ouen, F-75018, Paris(FR)**
Inventeur: **Bareyt, Claude, 5, rue de la Chataigneraie,
F-95160 Montmorency(FR)**

(74) Mandataire: **Weinmiller, Jürgen et al,
Lennéstrasse 9 Postfach 24, D-8133 Feldafing(DE)**

## Description

La présente invention se rapporte à un dispositif de commande automatique de gain, ou CAG, d'un récepteur de signaux, tels que des signaux de transmissions par satellite ou faisceaux hertziens, lesdits signaux étant transmis audit récepteur selon le mode dit "en Accès Multiple à Répartition Temporelle", ou AMRT (TDMA en anglais).

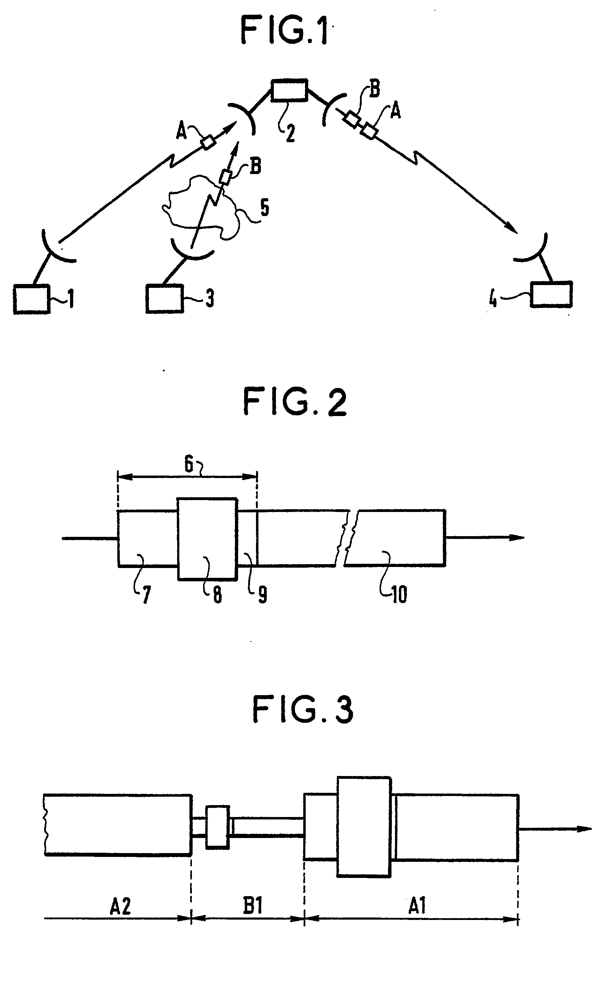

La figure 1 jointe représente schématiquement une transmission de conversations téléphoniques ou de données numériques par satellite du type AMRT.

Comme représenté sur cette figure, une première station d'émission 1 émet en direction du satellite de télécommunications 2 un premier paquet de données A reçu par le satellite entre les instants t et (t + to), tandis qu'une deuxième station d'émission 3 émet, un deuxième paquet de données B, reçu par le satellite entre les instants (t + to+ ε) et (t + to+ ε + tl) ; ε est un intervalle de temps très court, pouvant à la limite être nul. Ces paquets A et B transitent dans le satellite 2, et celui-ci les réémet à la suite l'un de l'autre vers une station de réception 4 comme schématisé sur le dessin. Le récepteur 4 verra donc arriver le paquet A puis, avec un temps de garde égal à ε, le paquet B.

Les paquets de données A et B qui transitent ainsi à travers le satellite 2 proviennent de directions différentes, et n'ont donc pas suivi le même trajet. Ils peuvent avoir subi des évanouissements, ou "fadings", différents. Si par exemple les conditions climatiques sont défavorables au-dessus de la station d'émission 3, par suite de la présence d'une zone de pluie 5, les paquets A et B n'auront pas le même niveau d'amplitudes à l'entrée du satellite 2, de sorte que la station de réception 4 démodulera des signaux pouvant présenter de grands écarts de niveau.

Pour fixer les idées, il est par exemple prévu, dans les réseaux de télécommunications par satellite INTELSAT et EUTELSAT, que les écarts de niveau entre paquets successifs pourront atteindre 5dB, leur niveau se situant dans une plage allant de +2 dB à -10 dB par rapport au niveau nominal de réception.

Il peut donc arriver que la station de réception 4 reçoive des signaux A ou B soit trop intenses soit trop faibles, ce qui entraîne une augmentation du taux d'erreur dans la réception de chaque signal, et donc une dégradation de la transmission. Comme, ainsi qu'on l'expliquera ci-après, il n'est à priori pas possible de munir le récepteur 4 d'un dispositif classique de Contrôle Automatique de Gain, ou CAG, comme pour les récepteurs de trafic courants, la seule solution existante à ce jour consiste à rectifier les différences de niveau de façon expérimentale. De manière classique donc, c'est l'opérateur se trouvant dans la station réceptrice 4 qui se charge de prévenir, en passant par les voies de service, la station d'émission 1 et/ou la station d'émission 3, de la mauvaise qualité de la réception de la transmission en leur provenance, et qui leur demande donc d'augmenter ou de baisser temporairement leur puissance d'émission.

Il va de soi qu'un tel procédé expérimental n'est pas satisfaisant sur le plan de la qualité de la réception, car son temps de réponse est nécessairement assez long, et parce qu'il est sujet à défaillance humaine, de sorte qu'un dispositif de Contrôle Automatique de Gain serait souhaitable pour le récepteur 4.

L'utilisation d'un dispositif de CAG classique n'est malheureusement pas envisageable, comme on l'a mentionné ci-dessus, pour un tel récepteur. Un dispositif de Contrôle Automatique de Gain a en effet un temps de réponse assez long et agit sur les signaux dont la puissance correspond à une moyenne générale de la puissance des signaux reçus. Dans ces conditions, les paquets de signaux, A ou B, qui correspondraient à une puissance faible par rapport à la moyenne, soit à cause de leur faible amplitude, soit à cause de leur faible durée, soit à cause des deux, ne subiraient aucune action de la part de la CAG, qui n'agirait que sur les paquets, A ou B, de puissance plus forte, de sorte que la démodulation des paquets se ferait dans de mauvaises conditions.

Bien entendu, l'utilisation d'un dispositif de CAG rapide n'est à priori pas non plus envisageable, puisqu'une telle correction rapide, si on pouvait la réaliser, agirait en égalisatrice de l'amplitude des signaux, de sorte que l'on détériorerait l'information. De telles CAG rapides n'ont d'ailleurs, à la connaissance de la Demanderesse, pas été réalisées à ce jour en particulier pour cette raison.

On sait par ailleurs qu'en AMRT, chaque paquet de données émis et reçu, A ou B sur la figure 1, est composé successivement d'une séquence d'acquisition, ou préambule, suivie des données, ou "datas", qui constituent l'information elle-même, sous forme numérique en général. Dans les systèmes INTELSAT et EUTELSAT par exemple, un paquet de données, A ou B sur la figure 1, comporte successivement, tel que schématisé sur la figure 2 jointe:

    – un préambule 6 composé de trois parties
- une première partie 7 composée par une onde non modulée de fréquence égale à la fréquence de l'onde porteuse des signaux, par exemple 140 MHz en fréquence intermédiaire, d'une durée brève, de l'ordre de une microseconde par exemple, destinée à permettre la récupération de la fréquence porteuse dans le démodulateur équipant le récepteur (4, figure 1),
- une partie 8 d'onde porteuse avec sauts de phase de π destinée à permettre la récupération de la fréquence d'horloge dans le démodulateur, l'onde porteuse y étant pratiquement totalement modulée par une onde sinusoïdale de période double de la période d'horloge, comme on le verra plus en détails ci-après,
- une dernière partie 9, constituée par un mot de reconnaissance ou "mot unique", codée numériquement et permettant, par exemple, de lever l'ambiguïté sur l'état de phase pour la porteuse correspondant au niveau 00 (cas de la modulation à quatre états de phase par exemple), ou en d'autres termes permettant de fixer la référence absolue de phase à la réception,

– une partie 10, en général sensiblement plus longue que l'ensemble du préambule 6, qui a par exemple lui-même une durée de 3 microsecondes et composée de l'ensemble de données, ou datas, du paquet, constituée elle aussi d'une succession de symboles à transmettre.

Une demande de brevet EP-A 0 151 916, qui ne peut être considérée qu'au titre de la nouveauté en application de l'article 54-3 de la CBE, décrit un circuit à contrôle automatique de gain comprenant un premier filtre qui reçoit le signal d'entrée, et des moyens de réglage du niveau qui délivrent le signal de sortie. Une boucle de retour est disposée entre l'entrée et la sortie de ces deuxième filtre dont la bande de bruit équivalente est inférieure à celle du premier filtre en réponse à une certaine composante de signal ayant un certain spectre de fréquence avec une certaine durée de manière à réaliser une intégration dans ce deuxième filtre.

La présente invention a pour objet un dispositif de commande automatique de gain d'un récepteur en Accès Multiple à Répartition Temporelle comportant:

– une voie de transmission directe du signal utile équipée d'un atténuateur commandé à temps de réponse rapide et, en sortie, un coupleur hybride dont une première sortie constitue la sortie fréence intermédiaire dudit dispositif, et dont la seconde sortie est reliée à un amplificateur-séparateur;

– une première boucle de réaction, reliée à la sortie dudit amplificateur-séparateur destinée à la commande de l'atténuateur et comportant successivement un dispositif de détection rapide, un dispositif de comparaison recevant la tension $V_1$ de référence de CAG, un échantillonneur commandé rapide, et un dispositif de mise en mémoire de la tension en sortie dudit échantillonneur commandé;

– une deuxième boucle de réaction, reliée à la sortie dudit amplificateur-séparateur destinée à la commande dudit échantillonneur commandé et comportant, en parallèle:

• d'une part une première voie comportant un filtre étroit centré sur une fréquence pure et un redresseur rapide à seuil;

• et d'autre part une deuxième voie comportant successivement un dispositif de détection rapide et un dispositif de comparaison recevant lui-même par ailleurs une tension de référence $V_2$, chacune de ces deux voies étant connectée respectivement aux deux bornes d'entrées d'une porte OU dont la sortie est reliée à la borne de commande dudit échantillonneur rapide.

L'invention sera mieux comprise à l'aide de la description suivante d'un exemple de réalisation, destinée à un réseau de télécommunications par satellite du type INTELSAT ou EUTELSAT, en référence aux dessins annexés dans lesquels:

– la figure 1, déjà décrite précédemment, est une représentation schématique d'un dispositif AMRT,

– la figure 2, déjà décrite précédemment, est une représentation schématique d'un paquet de données en réseau INTELSAT ou EUTELSAT, avec l'amplitude en ordonnées et le temps en abscisses,

– la figure 3 est une représentation schématique, selon l'axe des temps, des paquets de données reçus successivement par le récepteur de l'invention,

– la figure 4 est une représentation d'ensemble schématique du dispositif de Commande Automatique de Gain de l'invention,

– les figures 5A à 5D représentent schématiquement, selon l'axe des temps, les signaux relevés, pendant le défilement d'un paquet, en différents points du dispositif de la figure 4,

– la figure 6 est un schéma électrique de l'atténuateur variable équipant le dispositif de la figure 4,

– les figures 7A et 7B sont des schémas montrant la réalisation de l'onde, utilisée dans un ensemble AMRT concerné par l'invention, dite "en sauts de phase de $\pi$",

– la figure 8 est une représentation schématique d'un paquet de données en réseau, autre qu'INTELSAT ou EUTELSAT, dont toute la première partie du préambule est constituée par une onde en sauts de phase de $\pi$,

– la figure 9 est une représentation schématique, en variante, d'un dispositif selon la figure 4 adapté à la réception, selon l'invention, des paquets de données selon la figure 8.

En se reportant tout d'abord à l'ensemble des figures 1 à 3, les paquets de données A et B, en provenance respectivement des émetteurs 1 et 3 sont reçus successivement en hyperfréquences par le récepteur 4 après avoir transité dans le satellite 2.

Chaque paquet, A ou B, est composé, comme décrit précédemment, d'un préambule 6 suivi d'une séquence de données 10. Le préambule 6 lui-même, d'une durée totale de l'ordre de 3 $\mu$ s en fréquence intermédiaire par exemple, est composé d'une première partie 7, alors d'une durée de 1 $\mu$ s par exemple, d'onde non modulée à la fréquence porteuse, 140 MHz en Fréquence Intermédiaire par exemple, d'une deuxième partie 8 en sauts de phase de $\pi$, alors d'une durée de 2 $\mu$ s par exemple et d'une troisième partie de reconnaissance constituée par le "mot unique" codé en binaire, cette dernière partie durant alors par exemple 0,5 $\mu$ s pour fixer les idées. La séquence de données 10, qui représente l'information à transmettre, a une durée plus longue que celle du préambule 6, par exemple 100 $\mu$ s en Fréquence Intermédiaire pour fixer les idées.

Les paquets successifs arrivent, comme schématisé sur la figure 3, à la queue-leu-leu, $A_1$ $B_1$ $A_2$ etc...., dans le récepteur 4, l'intervalle les séparant étant ici supposé être nul. Les paquets en provenance de B, tel que le paquet $B_1$, sont de faible amplitude, affaiblis lors de leur passage à travers la zone de pluie 5 par exemple, de sorte que le récepteur 4 les reproduit avec un taux d'erreur important et que la communication en provenance de la station 3 s'en trouve dégradée.

Conformément à l'invention, on pallie à cet inconvénient en équipant l'étage à Fréquence Intermédiaire du récepteur 4 d'une CAG rapide, à temps de réponse, ou de réaction, de l'ordre de quelques centaines de nanosecondes par exemple, que l'on ne fait agir comme telle essentiellement que pendant la période 7 d'émission d'onde non modulée à fréquence porteuse, et constituant la première partie du préambule 6. Pendant ce temps, la tension de commande de cette CAG est mémorisée sur une capacité. Pratiquement dès la fin de la portion 7 du préambule, on coupe cette CAG rapide, mais on continue à la faire agir avec pour seule tension de commande la tension quasi-constante mémorisée sur ladite capacité. On augmente ainsi l'amplitude totale du paquet trop faible, tel que $B_1$, sans déformer ni les données 10, ni le mot de reconnaissance 9.

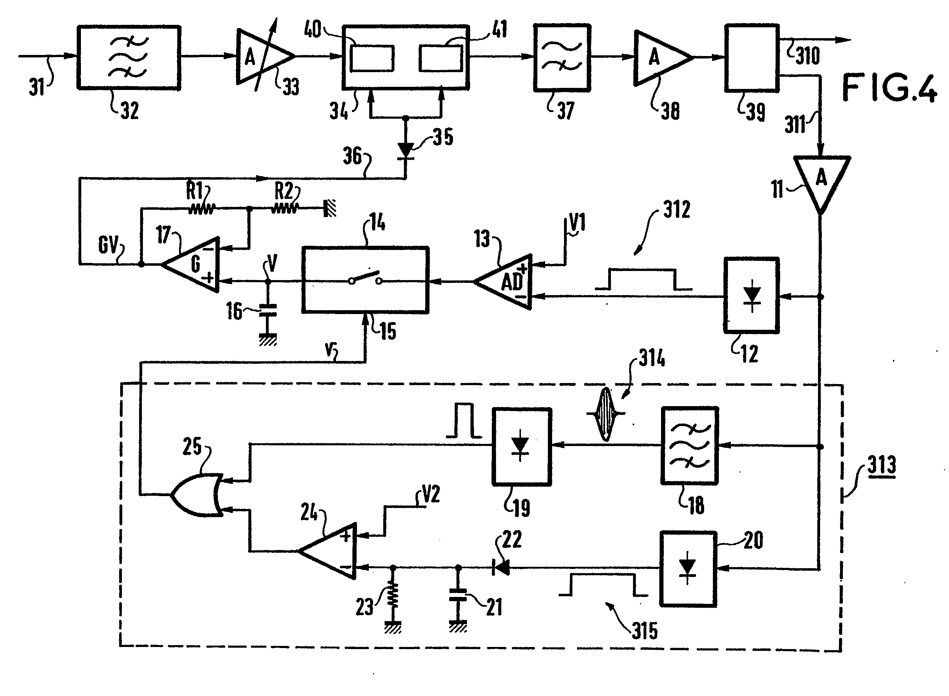

La figure 4 représente schématiquement le dispositif de CAG équipant, conformément à l'invention, l'étage à Fréquence Intermédiaire, ou FI, du récepteur 4 de la figure 1.

Sur cette figure 4, la référence 31 désigne la ligne d'arrivée en Fréquence Intermédiaire (140 MHz par exemple) des paquets non régulés, tels que les paquets $A_1$, $B_1$, $A_2$.....de la figure 3, après transposition, dans la première partie du récepteur 4, des signaux reçus par celui-ci en hyperfréquences, par exemple à 4 GHz, en Fréquence Intermédiaire, c'est-à-dire 140 MHz dans notre exemple. La référence 32 désigne un filtre passe-bande avec Correction de Temps de Propagation de Groupe, classique dans ce genre de récepteur, destiné à éviter de réguler les fréquences qui se trouvent en dehors de la bande du spectre de fréquences à passer ; par exemple dans notre cas, le filtre passe-bande 32 est un filtre à 140 MHz ± 40 MHz à 3 dB. De manière classique également, le signal issu du filtre passe-bande 32 est appliqué à un amplificateur 33 à gain réglable permettant d'ajuster, en gain et platitude, la courbe de réponse du filtre 32.

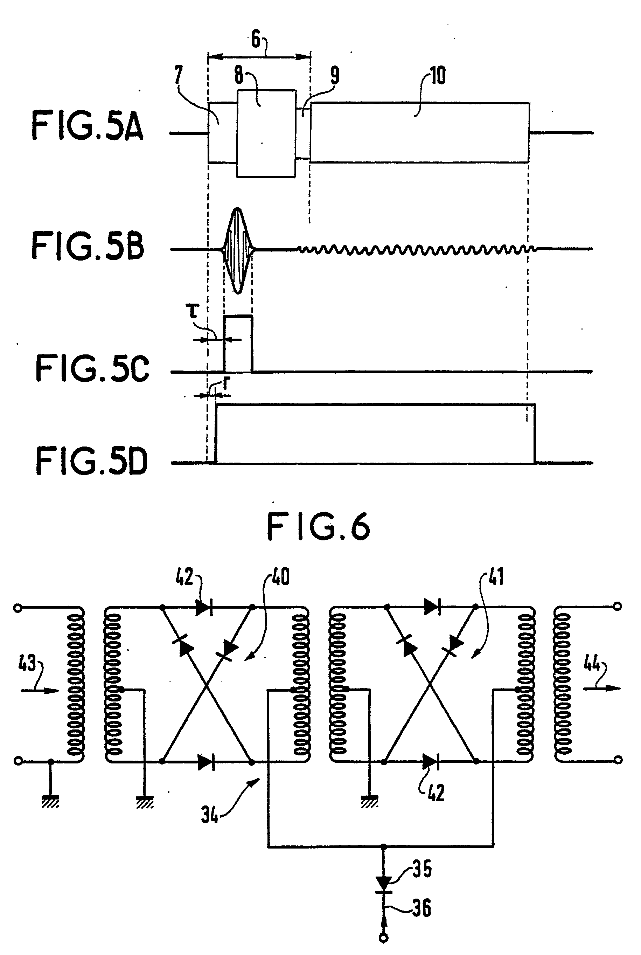

Conformément à l'invention, la sortie de l'amplificateur 33 est connectée à un atténuateur FI commandé 34 à temps de réponse rapide par rapport à la durée du préambule, par exemple l'ordre de la nanoseconde, et composé, comme schématisé sur la figure 6 qui sera décrite ultérieurement, de deux mélangeurs en anneau 40 et 41 à diodes très rapides, par exemple à diodes Schottky, mis en cascade et commandés en parallèle, à travers une diode de sélection 35, par la tension de CAG selon l'invention.

Le signal en sortie de l'atténuateur FI 34 passe successivement dans un filtre passe-haut 37 destiné à éviter les accrochages qui auraient tendance à apparaître, à quelques Mégahertz de fréquence par exemple, en raison de la rapidité de l'asservissement selon l'invention, puis dans un amplificateur classique 38 destiné à compenser la perte nominale de l'atténuateur 34 et enfin dans un coupleur hybride à 3dB 39 dont une première sortie 310 constitue la sortie FI régulée du dispositif de l'invention.

La deuxième sortie 311 du coupleur 39, qui constitue le début de la boucle de CAG de l'invention, est reliée comme représenté à un amplificateur de séparation 11.

La sortie de l'amplificateur-séparateur 11 est reliée à une première boucle 312 de réaction comportant successivement un détecteur d'amplitude 12 à temps de réponse rapide, de l'ordre de la nanoseconde, par exemple également à diodes Schottky, puis un amplificateur différentiel également très rapide 13 recevant sur son autre entrée la tension $V_1$ de référence classique de CAG, puis à un échantillonneur rapide 14 constitué par exemple par une porte analogique classique C.MOS, à temps de réponse de l'ordre de quelques dizaines de nanosecondes, commandée en 15 par la tension v en provenance de la seconde boucle décrite ci-dessous.

Une capacité 16, d'une valeur de 0,022 µF par exemple, est branchée entre la sortie de l'échantillonneur 14 et la masse. Elle sert de filtre passe-bas à l'asservissement de CAG, et elle sert en outre à mémoriser la tension en sortie V dudit échantillonneur 14. La tension V est d'autre part appliquée sur la borne + d'un amplificateur opérationnel 17, de gain G, fournissant donc à sa sortie une tension amplifiée GV. De manière classique, une résistance $R_1$ de contre-réaction est placée entre la sortie de l'amplificateur 17 et sa borne d'entrée - , et une résistance $R_2$ de définition du gain G est branchée entre sa borne d'entrée - et la masse, les résistances $R_1$ et $R_2$ ayant classiquement des valeurs de l'ordre de quelques kilohms.

La sortie en 36 de l'amplificateur opérationnel 17 est appliquée, comme mentionné précédemment, comme tension de commande de l'atténuateur rapide 34, à travers la diode de sélection 35.

La sortie de l'amplificateur-séparateur 11 est par ailleurs reliée à une deuxième boucle de réaction 313, destinée à la commande de l'échantillonneur 14 équipant la première boucle 312.

Cette deuxième boucle 313 comporte en parallèle, d'une part une première voie 314 reliant la sortie de l'amplificateur-séparateur 11 à une première borne d'entrée d'une porte OU 25 dont la sortie est reliée à la borne de commande 15 de l'échantillonneur 14, et d'autre part une deuxième voie 315 reliant la sortie de l'amplificateur-séparateur 11 à la deuxième borne d'entrée de ladite porte OU 25.

La première voie 314 de la boucle 313 comporte successivement un filtre passe-bande 18, à bande très étroite, par exemple 1 MHz à 3 dB, centré sur la fréquence porteuse, de 140 MHz dans notre exemple, puis un redresseur rapide à seuil 19.

La deuxième voie 315 de la boucle 313 comporte successivement un redresseur rapide 20, identique au détecteur 12 par exemple, puis une diode 22 de charge d'un condenseur 21, lui-même connecté entre la sortie de la diode 22 et la masse, de capacité de l'ordre de 10 F par exemple. Une résistance élevée 23 de l'ordre de 1 MΩ par exemple, destinée à la décharge très lente du condensateur 21, est par ailleurs branchée en parallèle sur le condensateur 21. La tension apparaissant aux bornes du condensateur 21 est appliquée sur la borne - d'un comparateur analogique 24 qui reçoit par ailleurs sur sa borne + une tension de référence $V_2$. La sortie du comparateur 24 est connectée, comme représenté, à la borne inférieure d'entrée de la porte OU 25.

On décrira maintenant le fonctionnement du dispositif de la figure 4, en s'aidant des diagrammes des figures 5A à 5D.

On décrira tout d'abord la séquence de démarrage qui est indispensable. En effet, à priori, en l'absence de tout signal d'entrée en 31 et la porte analogique 14 étant ouverte, la charge V de la capacité 16 est nulle, de sorte que la sortie 36 est à la masse et que l'atténuateur 34 est bloqué, de sorte qu'aucun signal en provenance de 31 ne peut passer et que le démarrage du dispositif est impossible. La voie 315 de la boucle 313 est destinée à éviter cette situation, et elle constitue donc le dispositif de démarrage du dispositif de CAG de l'invention.

Aucune tension n'existant aux bornes du condensateur 21, la tension sur la borne - du comparateur 24 est nulle, de sorte que, la tension de référence $V_2$ lui étant seule appliquée, sur sa borne +, la sortie du comparateur 24, est, par définition du fonctionnement de celui-ci et à cause de la tension $V_2$, à son niveau haut. Une tension de commande v existe donc en sortie de la porte OU 25, de sorte que la porte analogique 14 est fermée. En conséquence, la tension de référence de CAG $V_1$ maintient une certaine tension de charge $V_d$ sur la capacité 16, et l'amplificateur opérationnel 17 applique en 36 sur l'atténuateur 34 une certaine tension de commande $GV_d$, dite tension de commande de démarrage. Le démarrage du dispositif est donc ainsi rendu possible, et des paquets, tels que le paquet de la figure 5A qui peut par exemple être celui de la figure 2, se retrouvent sur le fil de sortie 31.

Conformément à l'invention, un paquet, tel que celui de la figure 5A, est régulé par le dispositif de la figure 4 de la façon suivante :

Le signal utile en sortie de l'amplificateur 38 est également appliqué, à travers le coupleur 39 et l'amplificateur 11, au détecteur rapide 12, qui fournit à sa sortie un signal rectangulaire, représenté en figure 5D, représentatif de l'enveloppe du paquet, et donc de même durée que celui-ci, avec un léger retard r introduit par le détecteur 12. Ce signal rectangulaire est appliqué, de manière classique pour une CAG, à l'amplificateur différentiel de CAG 13 qui fournit donc à sa sortie la tension de commande de CAG qui serait, dans un dispositif classique ne comportant pas l'échantillonneur 14, appliquée à l'atténuateur 34 pendant toute la durée du paquet. Conformément à l'invention, la tension différentielle en sortie de l'amplificateur 13 n'est appliquée telle qu'elle que pendant la durée de la première partie 7 du préambule 6 du paquet qui correspond à la transmission de la porteuse pure au retard absolu $\tau$ près.

Le signal utile en sortie de l'amplificateur 11 est dans ce but passé à travers le filtre étroit 18, centré sur la fréquence porteuse, dont la tension de sortie a donc une forme telle qu'apparaissant sur la figure 5b pendant la durée de ladite première partie 7 du préambule 6, et a une valeur soit nulle, soit très faible pendant le restant du paquet. Le détecteur 19 transforme ce signal en une impulsion rectangulaire selon la figure 5C, de durée légèrement inférieure à ladite partie 7 à fréquence porteuse, et légèrement en retard de $\tau$ par rapport à celle-ci du temps de transit dans le filtre étroit 18.

Par ailleurs, il est bien évidemment nécessaire, pendant la durée de la CAG de l'invention, et tant que la mémorisation dans la capacité 16 dure, d'inhiber la voie de démarrage 315, c'est-à-dire de mettre la sortie du comparateur 24 à son niveau bas. Pour ceci, le signal utile en sortie de l'amplificateur 11 est également détecté par le détecteur 20 qui en extrait un signal rectangulaire tel que représenté sur la figure 5D qui vient, pendant tout son temps de passage correspondant à l'enveloppe du paquet, charger la capacité 21, à travers la diode de charge 22, à une tension supérieure à $V_2$, cette dernière ayant été choisie en conséquence, de sorte que la sortie du comparateur 24 reste à son niveau bas pendant toute la durée de l'impulsion de la figure 5D et entre les paquets si il y en a suffisamment pour charger le condensateur 21 à une valeur supérieure au seuil $V_2$.

L'impulsion brève de la figure 5C issue du redresseur 19 est donc appliquée seule, après son passage par la porte OU 25 sur la borne de commande 15 de l'échantillonneur 14, et ferme donc pendant toute sa brève durée, la porte analogique formant ledit échantillonneur. La tension de CAG se trouvant pendant ce temps normalement présente en sortie de l'amplificateur différentiel 13, comme on l'a montré précédemment, le dispositif effectue, à la manière d'une CAG classique, mais très rapide, une régulation du signal par action sur l'atténuateur 34, ceci pendant toute la durée de l'impulsion de la figure 5C, c'est-à-dire, à un retard $\tau$ près, pendant la durée de la première partie 7 du préambule 6.

Pendant toute cette durée, le condensateur 16 se trouve être par ailleurs chargé à la tension de pointe V en sortie de l'amplificateur différentiel 13.

Lorsque l'impulsion rectangulaire de la figure 5C en sortie du détecteur 19 disparaît, plus aucun signal n'est appliqué sur l'une ou l'autre des entrées de la porte OU 25, de sorte que la tension de commande v en 15 devient nulle et que la porte analogique 14 s'ouvre instantanément, le signal normal de commande de CAG en sortie de l'amplificateur différentiel 13 n'étant alors plus appliqué.

Cependant, l'interrupteur commandé 14 s'étant ouvert, la capacité 16 n'a à ses bornes que la résistance d'entrée, extrêmement élevée puisque limitée aux résistances de fuite existant à la borne d'entrée + de l'amplificateur opérationnel 17. Cette capacité 16 reste donc chargée à la tension V de CAG à laquelle elle était chargée avant ladite ouverture de l'interrupteur 14, et ceci jusqu'à la prochaine impulsion 5C ou, si celle-ci ne vient pas, jusqu'à la prochaine phase de démarrage. Cette tension V, devenue GV en sortie de l'amplificateur opérationnel 17, reste donc appliquée, sans être modifiée, à travers la diode 35, en commande de l'atténuateur 34 pendant tout le temps de passage du restant du paquet, et même entre ce paquet et le suivant, régulant celui-ci et maintenant le gain entre les paquets dans exactement les mêmes conditions qu'il l'avait été pendant la durée de l'impusion de la figure 5C, c'est-à-dire sensiblement pendant la durée de la première partie 7 due préambule, au retard $\tau$ près.

Si, pendant un temps très long (quelques secondes), à l'échelle des paquets, aucun paquet n'est appliqué à l'entrée 31, le signal selon 5D ne vient plus charger régulièrement le condensateur 21 qui, au bout d'un temps très long à l'échelle des paquets, se décharge à travers la résistance 23, le signal en sortie du comparateur 24 remonte à son niveau haut, de sorte qu'un signal continu de commande de fermeture est à nouveau appliqué sur la borne de commande 15 de la porte analogique 14 et referme donc cette dernière. L'impulsion rectangulaire en sortie du détecteur 12, exactement identique et synchrone de celle apparaissant en sortie du détecteur 20, ayant également disparu, c'est à nouveau, tant qu'aucun nouveau paquet ne se présente, la tension $V_1$ de référence de CAG qui est appliquée, via la porte 14, l'amplificateur 17 et la diode 35, sur l'entrée de commande de l'atténuateur 34. La constante de temps de décharge de la capacité 21 dans la résistance 23 doit être grande devant la durée d'une trame qui contient par définition au moins un paquet.

La figure 6 montre, à titre indicatif, le schéma électrique de l'atténuateur rapide commandé 34 utilisé dans le dispositif de la figure 4. Comme on le voit sur le dessin, cet atténuateur, en soi nouveau dans ce type d'utilisation, est constitué de deux mélangeurs en anneau 40 et 41 à diodes Schottky, connus en soi, branchés en série et commandés en parallèle par l'arrivée 36, à travers la diode de sélection 35. Le signal en sortie de l'amplificateur 33 de la figure 4 est appliqué en 43 sur l'entrée du premier mélangeur en anneau 40, sur laquelle est normalement appliquée, dans les modulateurs à mélangeur en anneau classiques, l'onde de l'oscillateur local, et le signal de sortie en 44 du deuxième mélangeur en anneau 41, atténué par la tension appliquée aux deux mélangeurs en 36, est appliqué au filtre passe-haut 37 de la figure 4. L'utilisation d'un ou plusieurs mélangeurs en anneau, classiquement utilisés comme modulateurs d'amplitude, en atténuateur rapide commandé, est nouvelle à ce jour à la connaissance de la demanderesse. Le temps de réponse d'un tel mélangeur en anneau est de l'ordre de la nanoseconde, et est donc considérablement plus rapide que celui des atténuateurs commandés à diodes PIN couramment utilisés dans les CAG classiques, qui est plutôt de l'ordre de la microseconde.

Pour le dispositif de l'invention, un seul mélangeur en anneau tel que 40 pourrait suffire. On préfère cependant utiliser deux mélangeurs en anneau 40, 41, ou même plus de deux, branchés en cascade et commandés en parallèle pour réaliser une atténuation à bande suffisamment large.

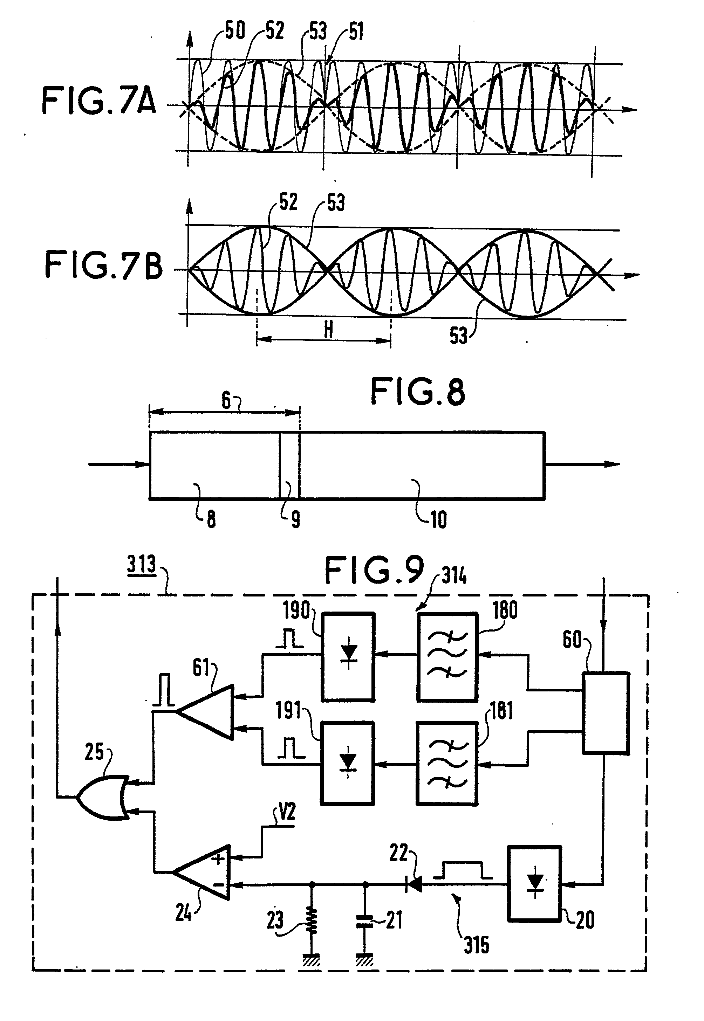

L'invention n'est bien évidemment pas limitée au mode de réalisation qui vient d'être décrit, plus spécialement adapté aux transmissions AMRT du type Instelsat et Eutelsat dans lesquelles le début du préambule 6 de chaque paquet (figure 2) est constitué par une onde pure 7 à fréquence porteuse. Elle s'applique à tout système tel que celui schématisé sur la figure 8, dans lequel le début du préambule 6 permet, éventuellement entre autres, une récupération de la porteuse pure.

La figure 8 schématise un paquet d'un autre système de transmission AMRT dans lequel le préambule 6 de chaque paquet est composé simplement d'une première partie 8 en sauts de phase de $\pi$, suivi du mot unique 9, ou mot de reconnaissance.

Les "sauts de phase de $\pi$" permettent en effet, comme on le rappellera ci-après, outre la récupération de l'horloge, la récupération de la porteuse pure.

Les figures 7A et 7B permettent, à titre d'explication de ce phénomène, de rappeler comment est réalisée la partie 8 "en sauts de phase de $\pi$".

En se reportant tout d'abord à la figure 7A, on réalise à l'origine l'onde en sauts de phase de $\pi$ en réalisant sur une onde porteuse pure 50 un saut de phase de $\pi$, tel qu'en 51, au rythme des symboles. En réalité, le spectre étant nécessairement tronqué par filtrage passe-bande, la tension réalisée à la forme de la courbe 52, c'est-à-dire celle représentée finalement en figure 7B qui est une onde à fréquence porteuse 52 totalement modulée par une autre onde sinusoïdale 53 de période double de la période d'horloge H, soit de fréquence égale à la moitié de la fréquence d'horloge $f_H$. Dans le spectre de fréquences, le spectre du signal en sauts de phase de $\pi$ de la figure 7B est donc uniquement composé de deux raies situées de part et d'autre de la fréquence porteuse, à des distances de celle-ci en fréquences égales à la moitié de la fréquence d'horloge. On peut donc réaliser avec ce genre de paquets une CAG conforme à l'invention en filtrant, au lieu de filtrer la fréquence pure comme c'était le cas pour le dispositif de la figure 4, soit l'une ou l'autre de ces deux raies, soit les deux. Seule la deuxième boucle 313 du dispositif de la figure 4 s'en trouve alors légèrement modifiée, comme il sera maintenant détaillé en référence à la figure 9.

Sur la variante de deuxième boucle 313, pour dispositif selon la figure 4, schématisée sur la figure 9, on a introduit, pour réaliser un couplage d'entrée à trois voies, un coupleur trois-voies supplémentaire 60, la voie inférieure 315 aboutissant sur l'entrée inférieure du circuit OU 25 étant par ailleurs inchangée comme on le voit sur le dessin.

La voie supérieure 314 est par contre différente. Elle comporte d'une part un premier filtre étroit 180, de mêmes caractéristiques de filtrage que le filtre 18 de la figure 4, mais de fréquence centrale réglée sur la raie inférieure de fréquence (f - $f_{H/2}$) f étant la fréquence porteuse à 140 MHz par exemple, et d'autre part un deuxième filtre étroit 181 du même type mais de fréquence centrale réglée sur la raie supérieure de fréquence (f + $f_{H/2}$), ces deux filtres étant chacun alimentés par le signal en sortie du coupleur 60. Les filtres étroits 180 et 181 sont respectivement suivis d'un détecteur à seuil, 190 et 191, identiques au détecteur 19 de la figure 4, et leurs impulsions étroites de sortie, qui sont par ailleurs synchrones, sont appliquées respectivement aux deux entrées d'un additionneur analogique 61 dont la sortie est appliquée sur la borne d'entrée supérieure de la porte OU 25.

Le fonctionnement d'un tel dispositif est identique à celui de la figure 4, la CAG rapide agissant dans ce cas essentiellement pendant la première partie 8 du préambule 6 du paquet schématisé sur la figure 8, au retard $\tau$, précédemment défini, près, et étant gardée en mémoire pendant le reste du temps, c'est-à-dire pendant le restant du paquet et entre le paquet et le suivant, sauf en période de démarrage.

## Revendications

1. Dispositif de commande automatique de gain d'un récepteur en Accès Multiple à Répartition Temporelle comportant:
- une voie (31 à 34, 37 à 39) de transmission directe du signal utile équipée d'un atténuateur commandé (34) à temps de réponse rapide et, en sortie, un coupleur hybride (39) dont une première sortie constitue la sortie fréquence intermédiaire dudit dispositif et dont la seconde sortie est reliée à un amplificateur-séparateur (11);
- une première boucle de réaction (312), reliée à la sortie dudit amplificateur-séparateur destinée à la commande de l'atténuateur (34) et comportant successivement un dispositif de détection rapide (12), un dispositif de comparaison (13) recevant la tension ($V_1$) de référence de CAG, un échantillonneur commandé (14) rapide, et un dispositif (16, 17) de mise en mémoire de la tension en sortie dudit échantillonneur commandé;
- une deuxième boucle de réaction (313), reliée à la sortie dudit amplificateur-séparateur (11) destinée à la commande dudit échantillonneur commandé (14) et comportant, en parallèle:
  • d'une part une première voie (314) comportant un filtre étroit (18) centré sur une fréquence pure, et un redresseur rapide à seuil (19);
  • et d'autre part une deuxième voie (315) comportant successivement un dispositif de détection rapide (20) et un dispositif de comparaison (21 à 24) recevant lui-même par ailleurs une tension de référence ($V_2$),
chacune de ces deux voies (314, 315) étant connectée respectivement aux deux bornes d'entrées d'une porte OU (25) dont la sortie est reliée à la borne de commande (15) dudit échantillonneur rapide (14).

2. Dispositif selon la revendication 1, caractérisé en ce que la voie de transmission directe du signal utile comprend successivement:
- un filtre passe-bande (32) avec Correction de Temps de Propagation de Groupe;
- un amplificateur (33) à gain réglable permettant d'ajuster, en gain et platitude, la courbe de réponse de ce filtre (32);
- un atténuateur FI commandé (34) à temps de réponse rapide;
- un filtre passe-haut (37);
- un amplificateur classique (38) destiné à compenser la perte nominale de l'atténuateur (34);
- et le coupleur hybride à 3dB (39) dont une première sortie (310) constitue la sortie FI régulée dudit dispositif.

3. Dispositif selon l'une quelconque des revendications 1 ou 2, caractérisé en ce que ledit atténuateur rapide (34), ainsi que lesdits dispositifs de détection rapides (12, 20) ont des temps de réponse de l'ordre de la nanoseconde.

4. Dispositif selon l'une quelconque des revendications précédentes, caractérisé en ce que ledit atténuateur rapide (34) est constitué par un mélangeur en anneau.

5. Dispositif selon l'une quelconque des revendications 1 à 3, caractérisé en ce que ledit atténuateur rapide (34) est constitué par plusieurs mélangeurs en anneau (40, 41) branchés en cascade et commandés en parallèle.

## Claims

1. An automatic gain control device in a time division multiple access receiver, comprising:
- a direct transmission path (31 to 34, 37 to 39) for the useful signal, equipped with a controlled attenuator (34) having a very short response time, and, at the output side, a hybrid coupler (39), of which one first output constitutes the intermediate frequency output of the present device, and of which the second output is connected to an isolating amplifier (11);
- a first feedback loop (312) connected to the output of said isolating amplifier for controlling the attenuator (34) and comprising in succession a high speed detector device (12), a comparator device (13) receiving the reference AGC voltage ($V_1$), a high speed controlled sampler (14), and a storage means (16, 17) for storing the output signal from said controlled sampler;
- a second feedback loop (313) connected to the output of said isolating amplifier (11) for controlling said controlled sampler (14) and comprising, in parallel on the one hand a first path (314) including a narrow band filter (18) centered on a pure frequency, and a high speed threshold rectifier (19), and, on the other hand, a second path (315) comprising in succession a high speed detection device (20) and a comparator device (21 to 24), which additionally receives a reference voltage ($V_2$), both of said paths (314, 315) being connected to respective input terminals of an OR gate (25) whose output is connected to the control terminal (15) of said high speed sampler (14).

2. A device according to claim 1, characterized in that the direct transmission path of the useful signal comprises in succession:
- a bandpass filter (32) incorporating group propagation delay correction,
- a variable gain amplifier (33) adapted to adjust the response curve of said filter (32) as to gain and flatness,
- a controlled intermediate frequency attenuator (34) having a rapid response,
- a highpass filter (37),
- a conventional amplifier (38) intended to compensate the nominal loss of the attenuator (34), and
- the hybrid 3 dB coupler (39), whose first output (310) constitutes the controlled intermediate frequency output of the device.

3. A device according to claim 1 or 2, characterized in that said high speed attenuator (34) as well as said high speed detector devices (12, 20) have response times of the order of one nanosecond.

4. A device according to anyone of the preceding claims, characterized in that said high speed attenuator (34) is constituted by a ring mixer.

5. A device according to anyone of claims 1 to 3, characterized in that said high speed attenuator (34) is constituted by a plurality of ring mixers (40, 41) connected in cascade and controlled in parallel.

## Patentansprüche

1. Einrichtung zur automatischen Verstärkungsregelung bei einem im Zeitmultiplex mit Vielfachzugriff arbeitenden Empfänger,
- mit einem direkten Übertragungskanal (31 bis 34, 37 bis 39) für das Nutzsignal, der ein gesteuertes Dämpfungsglied (34) kurzer Ansprechzeit sowie am Ausgang einen Richtkoppler (39) aufweist, bei dem ein erster Ausgang den Zwischenfrequenzausgang der Einrichtung bildet und ein zweiter Ausgang mit einem Trennverstärker (11) verbunden ist,
- mit einer ersten Rückkopplungsschleife (312), die an den zur Steuerung des Dämpfungsglieds (34) dienenden Ausgang des Trennverstärkers angeschlossen ist und in Reihenschaltung eine schnelle Erfassungsschaltung (12), eine die Bezugsspannung ($V_1$) der automatischen Verstärkungsregelung empfangende Vergleichsschaltung (13), einen gesteuerten, schnellen Tastkreis (14) und eine Vorrichtung (16, 17) zum Speichern der Ausgangsspannung des gesteuerten Tastkreises aufweist,
- mit einer zweiten Rückkopplungsschleife (313), die an den zur Steuerung des gesteuerten Tastkreises (14) dienenden Ausgang des Trennverstärkers (11) angeschlossen ist und in Parallelschaltung zum einen einen ersten Kanal (314) mit einem auf eine einzelne Frequenz zentrierten schmalbandigen Filter (18) sowie einem schnellansprechenden Schwellengleichrichter (19), und zum anderen einen zweiten Kanal (315) mit einer schnellansprechenden Detektorschaltung (20) sowie einer Vergleichsschaltung (21 bis 24) in Reihe aufweist, die ihrerseits weiter eine Bezugsspannung ($V_2$) empfängt, wobei jede der beiden Kanäle (314, 315) an eine der Eingangsklemmen eines ODER-Tores (25) angeschlossen ist, dessen Ausgang mit der Steuerklemme (15) des schnellansprechenden Abtasters (14) verbunden ist.

2. Einrichtung nach Anspruch 1, dadurch gekennzeichnet, daß der direkte Übertragungskanal für das Nutzsignal nacheinander folgende Komponenten aufweist:
- ein Bandpaßfilter (32) mit Gruppenlaufzeitkorrektur,
- einen Verstärker (33) mit regelbarem Verstärkungsgrad, der den Frequenzgang des Filters (32) bezüglich des Dämpfungsgrads und der Flachheit einzustellen gestattet,
- ein gesteuertes Dämpfungsglied im Zwischenfrequenzbereich (34), das rasch anspricht,
- ein Hochpaßfilter (37),
- einen klassischen Verstärker (38) zum Ausgleichen des Nominalverlustes des Dämpfungsgliedes (34), und
- den Richtkoppler (39) mit 3 dB, von dem ein erster Ausgang (310) den geregelten ZF-Ausgang der Einrichtung bildet.

3. Einrichtung nach einem der Ansprüche 1 oder 2, dadurch gekennzeichnet, daß das schnellansprechende Dämpfungsglied (34) sowie die schnellansprechenden Erfassungsschaltungen (12, 20) Ansprechzeiten im Nanosekundenbereich haben.

4. Einrichtung nach einem der vorhergehenden Ansprüche, dadurch gekennzeichnet, daß das schnellansprechende Dämpfungsglied (34) aus einem Ringmischer besteht.

5. Einrichtung nach einem der Ansprüche 1 bis 3, dadurch gekennzeichnet, daß das schnellansprechende Dämpfungsglied (34) aus mehreren Ringmischern (40, 41) besteht, die in Kaskade geschaltet sind und parallel gesteuert werden.

# FIG.1

# FIG.2

# FIG.3

FIG.4

FIG.5A

FIG.5B

FIG.5C

FIG.5D

FIG.6

FIG.7A

FIG.7B

FIG.8

FIG.9